# FASCICULE DE BREVET EUROPEEN

(11) **EP 2 481 135 B1**
(45) Date de publication et mention de la délivrance du brevet: **12.02.2014**
(21) Numéro de dépôt: 10762900.8
(22) Date de dépôt: 24.09.2010
(51) Int. Cl.: H01H 33/02, H02B 13/035, G01R 15/24

(54) **ENVELOPPE DE CONDUCTEUR ELECTRIQUE MUNIE DE CAPTEURS DE COURANT**
GEKAPSELTE LEITUNGSVORRICHTUNG MIT STROMSENSOREN
ELECTRICAL CONDUCTOR ENCAPSULATION PROVIDED WITH CURRENT SENSORS

(30) Priorité: 25.09.2009 FR 0956651
(43) Date de publication de la demande: 01.08.2012
(73) Titulaire: ALSTOM Technology Ltd, 5400 Baden (CH)
(72) Inventeur: JUGE, Patrice, F-74150 Marcellaz Albanais (FR); GRANELLI, Guillaume, F-74370 Argonay (FR)
(74) Mandataire: Ilgart, Jean-Christophe
(86) Numéro de dépôt international: PCT/EP2010/064123
(87) Numéro de publication internationale: WO 2011/036241

(56) Documents cités:
- EP-A1- 1 113 550
- EP-A1- 1 710 589
- EP-A2- 0 785 439
- WO-A1-2009/080109
- DE-A1- 10 015 800
- DE-B3- 10 254 385

## Description

Le sujet de l'invention est une enveloppe de conducteur électrique munie de capteurs de courant, et qui peut trouver emploi dans un appareillage électrique qui est un autre aspect de l'invention.

Certains appareillages électriques à moyenne ou haute tension tels que les postes sous enveloppe métallique (PSEM) ou les commutateurs isolés au gaz (GIS) comprennent un conducteur linéaire et une enveloppe rigide remplie d'un gaz isolant qui l'entoure à distance, tout en le soutenant par des entretoises isolantes en forme de disques. Ils sont munis de divers capteurs, dont des capteurs de courant pouvant être placés sur l'enveloppe et qui mesurent la circulation d'un courant dans le conducteur par induction électrique ou par effet Faraday, selon que l'élément sensible du capteur est un autre conducteur électrique ou une fibre optique. Les capteurs de ce genre sont enroulés sur l'enveloppe dans les deux cas en formant au moins une spire afin de capter un signal suffisant, et des appareils de mesure sont connectés à au moins une de leurs extrémités.

Cette dernière nécessité impose de percer l'enveloppe, dans le cas le plus fréquent où les capteurs sont logés dans un boîtier monté sur la face interne de l'enveloppe, mais cela représente l'inconvénient de rendre l'étanchéité de l'enveloppe plus difficile. Un autre inconvénient souvent observé est que le montage du capteur s'accompagne de discontinuités importantes de la section de l'enveloppe, qui entraînent des perturbations du courant de retour à haute fréquence qui apparaît notamment aux commutations de l'appareillage, et qui peuvent alors provoquer du rayonnement électromagnétique qui fausse les mesures des capteurs ou des arcs endommageant le gaz isolant dans l'enveloppe.

Un inconvénient général des capteurs montés à l'intérieur de l'enveloppe est enfin qu'ils imposent un démontage de celle-ci s'ils doivent être remplacés, ce qui est malencontreux puisqu'il faut, entre autres contraintes, éviter de relâcher le gaz isolant interne, toxique et polluant ; mais si les capteurs sont installés à l'extérieur de l'enveloppe, ce qu'on a choisi dans certaines conceptions connues, soit l'encombrement de l'appareillage est augmenté à cause d'un boîtier dans lequel ils sont protégés, soit ils sont laissés nus et exposés à des dommages.

Le document US-A-5 136 236 décrit un montage caractéristique de ces capteurs. Le document EP-A-1 710 589 décrit un autre montage, dans lequel les capteurs sont logés à l'intérieur de l'enveloppe dans des rainures d'un segment de l'enveloppe, les gorges s'ouvrant sur les faces planes d'extrémités du segment, touchant les segments voisins de l'enveloppe : un démontage complet de l'enveloppe est nécessaire pour les capteurs. Le document US-A-4 320 337 décrit un montage des capteurs à l'extérieur de l'enveloppe. Et le document GB-A-2 332 784 décrit un montage où les capteurs sont montés sur une bobine installée autour du conducteur, sans contact avec l'enveloppe : cette conception n'évite pas les inconvénients de devoir démonter l'enveloppe pour les remplacer, et on peut supposer que la mesure du signal du capteur à travers tout un rayon de l'appareillage sera problématique.

On citera encore le document DE-A-100 15 800, mais qui ne divulgue pas, entre autres, une entretoise interne continue de manière à préserver l'étanchéité de l'enveloppe en s'étendant d'une bride à une autre de l'enveloppe ; WO-A-2009/080109 et EP-A-1 193 550, qui décrivent des capteurs logés dans des cavités dépourvues d'ouvertures ; EP-A-0 785 439, qui décrit des capteurs logés dans des gorges mais pas de façon à pouvoir y être guidés par enfoncement, le remplacement des capteurs imposant donc un démontage complet de l'installation électrique ; et DE-B-102 54 385, qui décrit seulement des collerettes (23 et 24) entre lesquelles des capteurs peuvent être installés à l'extérieur de l'enveloppe.

L'enveloppe caractéristique de l'invention est dépourvue des inconvénients précédents : elle permet une installation et un remplacement aisés du capteur ou des capteurs et elle ne perturbe pas la circulation de courants dans l'enveloppe, ni l'étanchéité de l'enveloppe.

Sous une forme générale, elle concerne une enveloppe de conducteur électrique, conforme à la revendication 1.

L'enveloppe peut comprendre une pluralité de telles ouvertures et de telles gorges, chacune des gorges débouchant dans une ouverture respective, les ouvertures étant de préférence décalées angulairement autour de l'enveloppe à la fois pour mieux distinguer les capteurs et pour offrir des gains de place pour les dispositifs de mesure.

Cette conception permet de mettre le capteur ou les capteurs à l'abri entre deux parois concentriques de l'enveloppe, en s'assurant qu'il est bien placé grâce au guidage dans la gorge. La paroi extérieure comporte l'ouverture d'installation du capteur, mais la paroi interne reste continue, ce qui préserve l'étanchéité. L'extrémité de mesure du capteur reste accessible à travers l'ouverture. Le seul encombrement supplémentaire nécessité par le capteur correspond au boîtier de mesure. Et les perturbations électriques sont réduites tant que l'enveloppe qui abrite le capteur prolonge bien les autres en ayant des dimensions analogues de rayon.

La gorge peut être établie sur une face de la cavité, ou dans un tube fixé à la cavité. Quoi qu'il en soit, elle peut être formée dans une matière à frottement plus faible qu'une matière prépondérante (métallique) de l'enveloppe, afin de permettre des montages et démontages plus faciles.

L'enveloppe peut être montée en prolongement d'autres enveloppes, pleines, c'est-à-dire dépourvues de cavité, du conducteur. Elle est avantageusement composée de deux pièces pourvues chacune d'une bride plate de fixation à une des autres enveloppes et d'une entretoise, les entretoises étant munies de faces de centrage mutuel, une des entretoises prolongeant les autres enveloppes et butant directement contre la bride de l'autre des pièces, l'autre des entretoises étant jointe à l'autre des pièces par une garniture d'étanchéité isolante de l'électricité. L'appareillage peut comprendre une pluralité de tels capteurs filiformes logés dans la gorge de la cavité, dont un capteur à fibre optique et un capteur à transformateur de courant conjoints, ce qui peut améliorer la qualité des mesures.

La perturbation à la forme de l'enveloppe générale est alors minime, ainsi que les irrégularités causées aux courants.

L'invention sera maintenant décrite en liaison aux figures suivantes :
- la figure 1 est une vue générale d'une implantation de l'invention,
- la figure 2 est une première vue d'une réalisation d'enveloppe d'appareillage électrique selon l'invention,
- la figure 3 est une deuxième vue,
- la figure 4 est une vue en éclaté d'une autre réalisation de l'invention,
- la figure 5 illustre une variante,
- et la figure 6 est une représentation d'un capteur.

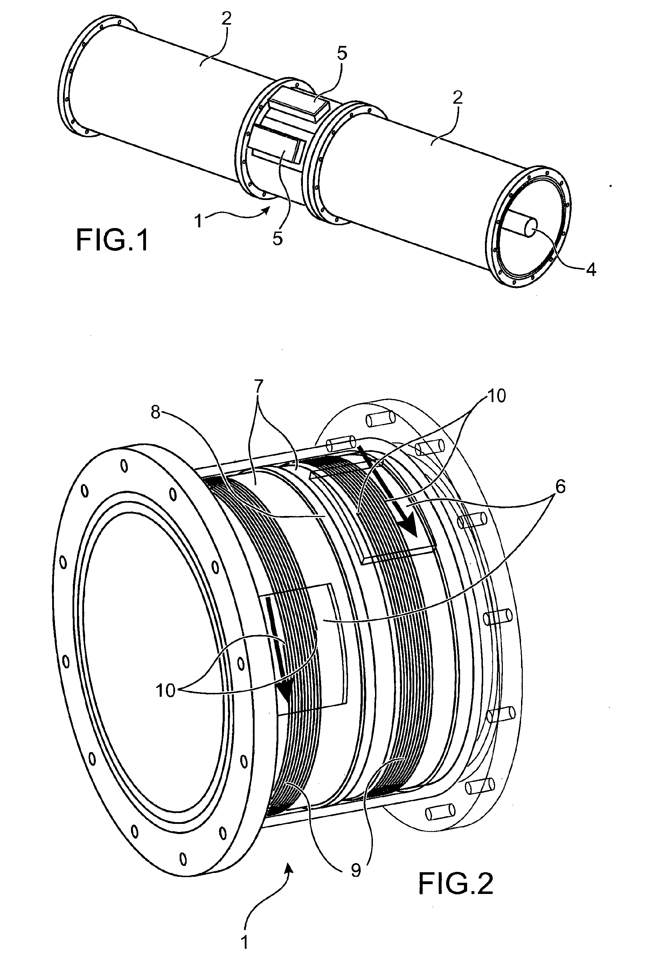

La figure 1 est une vue extérieure d'une portion d'enveloppe d'un appareillage électrique tel qu'un poste PSEM ou GIS, dont l'élément caractéristique de l'invention est une enveloppe 1 centrale, qu'on a représentée bridée à deux autres enveloppes 2, cylindriques et lisses. Un conducteur 4 s'étend au centre des enveloppes 1 et 2, qui l'isolent de l'extérieur. L'enveloppe 1, servant à porter des capteurs, peut être plus courte que les autres. On a représenté ici un agencement à deux capteurs, puisque les avantages de l'invention sont plus manifestes quand plusieurs capteurs sont employés, mais on pourrait parfaitement envisager l'emploi d'un seul capteur. La figure 1 étant une vue extérieure, on voit seulement les boîtiers de mesure 5, qui sont montés à l'extérieur de l'enveloppe 1, à deux emplacements angulaires différents, chacun sur la plus grande partie de la longueur de l'enveloppe 1. Si on retire les boîtiers 5, on démasque deux ouvertures 6 décalées longitudinalement et angulairement sur l'enveloppe 1 comme le représente la figure 2 ; les ouvertures 6 mènent à une cavité 7 à l'intérieur de l'enveloppe 1, qui peut être selon le cas commune aux deux ouvertures ou divisée par une nervure 8, et la cavité 7 comprend ici deux tubes 9 s'enroulant autour de l'enveloppe 1 en formant ici une pluralité de spires et dont les extrémités 10 s'ouvrent devant une ouverture 6 respective. Les tubes 9 servent à loger les capteurs, ici à fibre optique exploitant l'effet Faraday des courants passant par le conducteur 4. Les capteurs sont enfoncés par les ouvertures 6 dans les tubes 9, qui servent à les guider et à les maintenir à une position favorable à la mesure sans leur permettre de glisser dans la cavité 7. L'extension angulaire et longitudinale limitée des ouvertures 6, qui s'étendent sur de petites portions de l'enveloppe 1, permet de protéger les tubes 9 et les capteurs eux-mêmes par l'enveloppe 1. La possibilité de monter ou de remplacer les capteurs par de simples mouvements d'enfoncement évite de devoir jamais démonter l'enveloppe 1. Les tubes 9 sont collés ou fixés d'une manière quelconque dans les cavités 7. Ils sont avantageusement en matière à frottement plus faible que la matière de l'enveloppe 1, comme en PTFE : l'introduction des capteurs, de même que leur enlèvement afin de les remplacer, sont alors faciles.

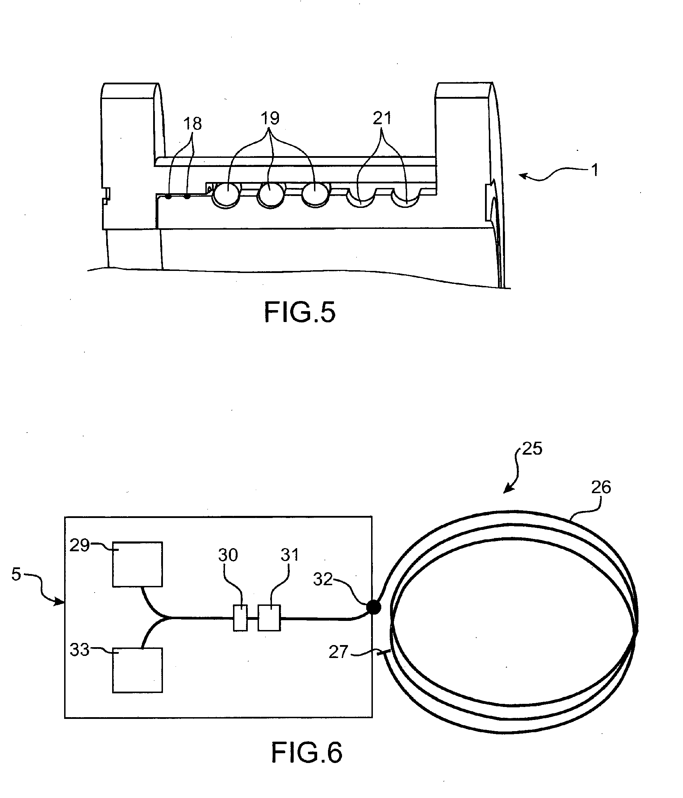

Un capteur de courant 25 idoine est représenté à la figure 6. Il comprend une fibre optique 26 comme élément sensible, avec un miroir 27 à une extrémité et le boîtier 5 à l'autre. Ce dernier comprend les éléments nécessaires à l'exploitation du capteur, à savoir une source de lumière 29, un polariseur 30, en ondulateur 31, un polariseur circulaire 32, et un photo-détecteur 33. La lumière émise par la source 29 parcourt la fibre 26 après avoir traversé les éléments 30 à 32, puis revient jusqu'au photo-détecteur 33 après avoir été réfléchie par le miroir 27. La fibre optique 26 est enroulée en spires autour du conducteur 4, qui n'est pas représenté ici, mais dont le courant influence la lumière qui le parcourt d'une façon qui peut être mesurée.

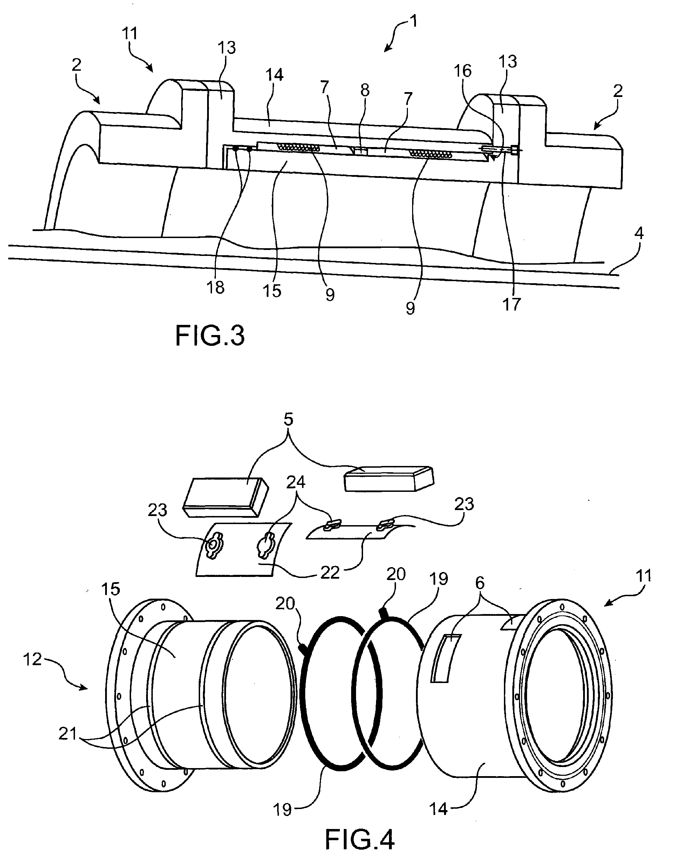

Une autre représentation est celle de la figure 3. L'enveloppe 1 se compose de deux portions 11 et 12, dont chacune comprend une bride 13 et une entretoise jointive à la bride, respectivement une entretoise externe 14 et une entretoise interne 15. Les entretoises 14 et 15 sont concentriques et la cavité 7 s'étend entre elles. L'assemblage est réalisé par des surfaces de butée 16 entre les entretoises 14 et 15, près des brides 13 et qui apportent un centrage mutuel préservant la concentricité des entretoises 14 et 15. Des vis 17 assemblent une des brides 13 à l'entretoise (ici l'entretoise externe 14) de l'autre pièce. Une garniture d'étanchéité 18 est prévue à la jonction entre l'autre entretoise 15 et l'autre bride 13. Il est avantageux que cette garniture soit aussi isolante de l'électricité à condition que les enveloppes 2 lisses prolongent l'entretoise externe 14, puisque la circulation de courants de retour à travers l'entretoise interne 15 est alors contrariée et que ces courants s'écoulent donc de façon presque rectiligne et régulière à travers les enveloppes 1 et 2 en passant exclusivement par l'entretoise externe, sans perturbation responsable d'un rayonnement.

On passe aux commentaires de la figure 4, qui illustrent une réalisation un peu différente dans laquelle on utilise des transformateurs de courant fonctionnant selon la méthode de Rogowski. Ces capteurs, portant la référence 19, se présentent sous forme d'une boucle à spire unique refermée sur elle-même à une extrémité, où ils sont munis de bornes de connexion 20 aux boîtiers 5. Ils consistent essentiellement en un conducteur façonné en enroulements empilés le long de la spire et dont les extrémités sont reliés à une borne 20. Les boîtiers de connexion 5 de ce genre de capteurs ont évidemment un contenu adapté à des éléments sensibles électriques. Ces capteurs étant connus, ils ne seront pas décrits plus ici. Quoiqu'il soit possible de les installer en utilisant des tubes analogues aux tubes 9, ici d'une seule spire, on peut envisager un autre mode d'installation, reposant sur l'emploi de gorges 21 entaillant une des entretoises, ici l'entretoise interne 15, et qui ont les mêmes propriétés de guidage. On a représenté aussi des plaquettes 22 de couverture qu'on pose sur les ouvertures 6 et sur lesquelles on pose ensuite les boîtiers de connexion 5. Ces plaquettes 22 peuvent être semblables et munies chacune d'un bossage à ouverture 23 destiné au passage de la borne de connexion 20 et d'un bossage continu 24. Une fois que les capteurs 19 ont été placés dans les gorges 21 et que leurs spires ont été fermées, les plaquettes 22 sont posées sur l'entretoise externe 14 en étant tournées de façon que les bossages à ouverture 23 viennent devant les ouvertures 6 et les bornes de connexion 20. On emboîte alors les boîtiers de connexion 5 sur les bossages 23 et 24 et les bornes de connexion 20. Un montage serré est obtenu, par un collier de fixation enserrant les boîtiers de connexion 5 ou par tout autre autre moyen de serrage sur les bornes de connexion 20.

Les gorges 21 peuvent être ici aussi revêtues de matière à faible frottement pour faciliter l'introduction des capteurs 19.

Une variante de réalisation est représentée à la figure 5 : toute l'entretoise interne 15 est munie de gorges 21 placées à intervalle régulier, ici cinq, et dont certaines sont surnuméraires, seuls trois capteurs 19 étant ici installés. Cette conception permet d'ajouter, en cas de besoin, de nouveaux capteurs pendant la durée de vie de l'appareillage. Cela ne soulève aucune difficulté avec les ouvertures 6 placées toutes à des emplacements angulaires différents.

Les dispositifs à tubes et à gorges ne sont pas nécessairement associés respectivement aux capteurs à fibre optique et aux capteurs à transformateur.

Une conception voisine de celle de la figure 5 pourrait être adoptée avec des capteurs à fibre optique. Le nombre de spires des capteurs n'est pas critique pour une bonne exécution de l'invention : il suffit de prévoir des dispositifs de guidage et de réception appropriés.

Enfin, les capteurs des deux catégories peuvent être placés ensemble sur une même enveloppe 1, ce qui peut même être très avantageux pour la sûreté des mesures.

## Revendications

1. Enveloppe (1) de conducteur électrique, l'enveloppe étant rigide et distante du conducteur électrique (4) qu'elle entoure, composée de deux pièces (11, 12) assemblées l'une à l'autre, l'enveloppe comprenant deux brides (13) de fixation à d'autres enveloppes (2) et deux entretoises (14, 15) s'étendant entre les brides, les entretoises étant concentriques, une cavité circulaire (7) constituant un intervalle entre les entretoises, l'entretoise interne étant continue de manière à préserver l'étanchéité de l'enveloppe et l'entretoise externe étant munie d'au moins une ouverture (6), ayant une extension angulaire limitée, d'installation d'un capteur filiforme (19, 25) de courant du conducteur, la cavité étant occupée par au moins une gorge (9, 21) de guidage dudit capteur par enfoncement dudit capteur, la gorge comprenant au moins une spire et débouchant sur l'ouverture.

2. Enveloppe de conducteur électrique selon la revendication 1, **caractérisée en ce que** la cavité comprend une pluralité d'ouvertures (6) et une pluralité de gorges (9, 21), chacune des gorges débouchant dans une ouverture respective, les ouvertures étant décalées angulairement autour de l'enveloppe.

3. Enveloppe de conducteur électrique selon l'une quelconque des revendications 1 ou 2, **caractérisée en ce que** la gorge (21) est établie sur une face de la cavité.

4. Enveloppe de conducteur électrique selon l'une quelconque des revendications 1 ou 2, **caractérisée en ce que** la gorge est établie dans un tube (9) fixé à la cavité (7).

5. Enveloppe de conducteur électrique selon l'une quelconque des revendications précédentes, **caractérisée en ce que** la gorge est formée dans une matière à frottement plus faible qu'une matière prépondérante de l'enveloppe (1).

6. Appareillage électrique comprenant une enveloppe (1) selon l'une quelconque des revendications précédentes, montée entre d'autres enveloppes (2), lisses, du conducteur.

7. Appareillage électrique selon la revendication 6, **caractérisé en ce que** les deux pièces sont pourvues chacune d'une des brides et d'une des entretoises, les entretoises sont munies de faces (16) de centrage mutuel, une des entretoises (14) prolongeant lesdites autres enveloppes (2) et butant directement contre la bride de l'autre des pièces, l'autre des entretoises étant jointe à l'autre des pièces par une garniture d'étanchéité (18) isolante de l'électricité.

8. Appareillage électrique selon l'une quelconque des revendications 6 ou 7, **caractérisé en ce qu'**il comprend une pluralité de capteurs filiformes (19, 25) de courant du conducteur, logés dans la gorge de guidage de la cavité de l'enveloppe.

9. Appareillage électrique selon la revendication 8, **caractérisé en ce que** les capteurs comprennent un capteur à fibre optique et un capteur à transformateur de courant.

## Patentansprüche

1. Gehäuse (1) für elektrische Leiter, wobei das Gehäuse starr und von dem elektrischen Leiter (4) beabstandet ist, den es umgibt, und aus zwei zusammengefügten Teilen (11, 12) besteht, wobei das Gehäuse zwei Flansche (13) zum Befestigen an weiteren Gehäusen (2) und zwei Stege (14, 15) aufweist, die sich zwischen den Flanschen erstrecken, wobei die Stege konzentrisch verlaufen und ein kreisförmiger Hohlraum (7) einen Zwischenraum zwischen den Stegen bildet, wobei der innere Steg kontinuierlich verläuft, so dass er die Dichtheit des Gehäuses sicherstellt und der äußere Steg mit zumindest einer Öffnung (6) mit begrenzter Winkelerstreckung für die Montage eines drahtförmigen Stromsensors (19, 25) für den Leiter versehen ist, wobei der Hohlraum von zumindest einer Führungsnut (9, 21) zum Führen des Sensors durch Eindrücken des Sensors eingenommen wird, wobei die Nut zumindest eine Windung aufweist und an der Öffnung ausmündet.

2. Gehäuse für elektrische Leiter nach Anspruch 1, **dadurch gekennzeichnet, dass** der Hohlraum eine Mehrzahl von Öffnungen (6) und eine Mehrzahl von Nuten (9, 21) aufweist, wobei jede der Nuten in einer jeweiligen Öffnung ausmündet, wobei die Öffnungen um das Gehäuse herum im Winkel versetzt sind.

3. Gehäuse für elektrische Leiter nach einem der Ansprüche 1 oder 2, **dadurch gekennzeichnet, dass** die Nut (21) an einer Seite des Hohlraums ausgebildet ist.

4. Gehäuse für elektrische Leiter nach einem der Ansprüche 1 oder 2, **dadurch gekennzeichnet, dass** die Nut in einem am Hohlraum (7) befestigten Rohr (9) ausgebildet ist.

5. Gehäuse für elektrische Leiter nach einem der vorangehenden Ansprüche, **dadurch gekennzeichnet, dass** die Nut aus einem Material mit geringerer Reibung als ein vorwiegendes Material des Gehäuses (1) ausgebildet ist.

6. Elektrische Einrichtung mit einem Gehäuse (1) nach einem der vorangehenden Ansprüche, die zwischen weiteren glatten Gehäusen (2) des Leiters montiert ist.

7. Elektrische Einrichtung nach Anspruch 6, **dadurch gekennzeichnet, dass** die beiden Teile jeweils mit einem der Flansche und einem der Stege versehen sind, wobei die Stege mit Seiten (16) zur gegenseitigen Zentrierung versehen sind, wobei einer der Stege (14) die weiteren Gehäuse (2) fortsetzt und unmittelbar an den Flansch des weiteren Teils anschlägt, wobei der weitere Steg mit dem weiteren Teil über einen stromisolierenden Dichtungsbelag (18) verbunden ist.

8. Elektrische Einrichtung nach einem der Ansprüche 6 oder 7, **dadurch gekennzeichnet, dass** sie eine Mehrzahl von drahtförmigen Stromsensoren (19, 25) für den Leiter enthält, die in der Führungsnut des Hohlraums des Gehäuses aufgenommen sind.

9. Elektrische Einrichtung nach Anspruch 8, **dadurch gekennzeichnet, dass** die Sensoren einen faseroptischen Sensor und einen Stromwandlersensor enthalten.

## Claims

1. An electricity conductor enclosure (1), the enclosure being rigid and distant from the electricity conductor (4) that it surrounds, the enclosure (1) being made up of two parts (11, 12) fastened one to the other, the enclosure being provided with two flanges (13) for fastening to other enclosures (2) and with two spacers (14, 15) which extend between the flanges, the spacers being concentric, a circular cavity (7) constituting an interval between the spacers, the internal spacer being continuous in order to preserve sealing of the enclosure and the external spacer being provided with at least one opening (6), having a limited angular extension, for installing a filiform current sensor (19, 25) for sensing the current of the conductor, the cavity being occupied by at least one guide groove (9, 21) for guiding said sensor when pushing said sensor, the groove including at least one loop and opening out into the opening.

2. An electricity conductor enclosure according to claim 1, **characterized in that** the cavity includes a plurality of openings (6) and a plurality of grooves (9, 21), each of the grooves opening out into a respective opening, the openings being offset angularly about the enclosure.

3. An electricity conductor enclosure according to any one of claims 1 and 2, **characterized in that** the groove (21) is established on a face of the cavity.

4. An electricity conductor enclosure according to any one of claims 1 or 2, **characterized in that** the groove is established in a tube (9) that is fastened to the cavity (7).

5. An electricity conductor enclosure according to any one of the preceding claims, **characterized in that** the groove is made of a material presenting friction that is lower than a preponderant material of the enclosure (1).

6. Electrical apparatus including an enclosure (1) according to any one of the preceding claims, assembled between other conductor enclosures (2) that are smooth.

7. Electrical apparatus according to claim 6, **characterized in that** the two parts are each provided with one of the flanges and one of the spacers, the spacers being provided with mutual centering faces (16), one of the spacers (14) extending said other enclosures (2) and coming directly into abutment against the flange of the other part, the other one of the spacers coming into abutment against the other part via a sealing gasket (18) that is electrically insulating.

8. Electrical apparatus according to any one of the claims 6 and 7, **characterized in that** it includes a plurality of filiform current sensors (19, 25) for sensing the current of the conductor, housed in the guide groove of the enclosure cavity.

9. Electrical apparatus according to claim 8, **characterized in that** the sensors include an fiber optic sensor and a current transformer sensor.
